# EUROPEAN PATENT APPLICATION

(11) **EP 4 780 175 A1**
(43) Date of publication of application: **22.07.2026**
(21) Application number: 23817938.6
(22) Date of filing: 20.10.2023
(51) Int. Cl.: H10H 29/01, H10H 20/853

(54) **DISPLAY PANEL AND MANUFACTURING METHOD FOR DISPLAY PANEL**

(30) Priority: 11.09.2023 CN 202311170188
(71) Applicant: TCL China Star Optoelectronics Technology Co., Ltd., Shenzhen, Guangdong 518132 (CN)
(72) Inventor: LI, Yanfen, Shenzhen Guangdong 518132 (CN); CHEN, Lixuan, Shenzhen Guangdong 518132 (CN)
(74) Representative: Nederlandsch Octrooibureau
(86) International application number: PCT/CN2023/125693
(87) International publication number: WO 2025/055059

(57) **Abstract**

This application discloses a display panel and a method of manufacturing the display panel. The display panel includes an edge portion and a non-edge portion at least partially surrounded by the edge portion. The display panel includes a substrate, an array composite layer disposed on the substrate, a plurality of light-emitting diodes disposed on the array composite layer, and an encapsulation layer disposed on the plurality of light-emitting diodes. At the edge portion, the array composite layer exposes the substrate, and the encapsulation layer is disposed in contact with the substrate.

## Description

### TECHNICAL FIELD

The present disclosure relates to the field of display, and more particularly, to a display panel and a method of manufacturing a display panel.

### BACKGROUND

With the development of display technology, display panels have been widely used in people's lives, such as display screens of mobile phones, computers, and televisions. Micro light-emitting diodes (Min-LED, Micro-LED, etc.) display panels have been developed, which have advantages of cross generation in brightness, resolution, energy consumption, service life, response speed and thermal stability, and are internationally recognized as the future display technology.

However, current micro-LED display panels have a problem that moisture or oxygen enters the interior from the side, resulting in a decrease in the life span and failure of the micro-LED display panels.

### SUMMARY

Embodiments of the present disclosure provide a display panel and a method of manufacturing the display panel, which can solve the problem in the current micro-LED display panels that moisture or oxygen enters the interior from the side, resulting in a decrease in the life span and failure of the micro-LED display panels.

The present disclosure provides a display panel including an edge portion and a non-edge portion at least partially surrounded by the edge portion, the display panel includes:
a substrate;
an array composite layer disposed on the substrate;
a plurality of light-emitting diodes disposed on the array composite layer; and
an encapsulation layer disposed on the plurality of light-emitting diodes;
wherein at the edge portion, the array composite layer exposes the substrate, and the encapsulation layer is disposed in contact with the substrate.

Optionally, in some embodiments of the present disclosure, the encapsulation layer includes a cover plate layer and an optical adhesive layer disposed between the cover plate layer and the plurality of light-emitting diodes, and at the edge portion, the optical adhesive layer connects the substrate and the cover plate layer.

Optionally, in some embodiments of the present disclosure, the display panel includes a frame portion and a display portion at least partially surrounded by the frame portion;
the edge portion includes a first edge portion corresponding to the frame portion, and the non-edge portion includes a first non-edge portion corresponding to the display portion.

Optionally, in some embodiments of the present disclosure, the display panel includes a frame portion and a display portion at least partially surrounded by the frame portion;
the display portion includes the plurality of the light-emitting diodes, and at least one opening is disposed between at least part of two adjacent light-emitting diodes; and
the edge portion includes a second edge portion corresponding to the opening, and the non-edge portion includes a second non-edge portion corresponding to the light-emitting diode on one side of the opening.

Optionally, in some embodiments of the present disclosure, the array composite layer forms a first slope at a boundary between the edge portion and the non-edge portion, the optical adhesive layer covers the first slope, and an included angle formed between the first slope and the substrate of the edge portion is an obtuse angle.

Optionally, in some embodiments of the present disclosure, the array composite layer includes a conductive metal oxide layer and a thin film transistor layer, the thin film transistor layer forms a second slope corresponding to the first slope, the metal oxide layer includes a first sub-protection portion, the first sub-protection portion covers the second slope and extends to the edge portion to contact the substrate, and the optical adhesive layer covers the first sub-protection portion.

Optionally, in some embodiments of the present disclosure, an included angle formed between the second slope and the substrate of the edge portion ranges from 110 degrees to 140 degrees.

Optionally, in some embodiments of the present disclosure, the array composite layer further includes a first insulating layer disposed between the thin film transistor layer and the metal oxide layer, the metal oxide layer includes a second sub-protection portion disposed at the non-edge portion, and a whole surface of the second sub-protection portion is disposed on the first insulating layer.

Optionally, in some embodiments of the present disclosure, the first insulating layer is a flat layer of an organic material.

Optionally, in some embodiments of the present disclosure, layer structures of the thin film transistor layer include:
a plurality of thin film transistors disposed on the substrate, each of the plurality of thin film transistors includes at least a semiconductor layer, a gate insulating layer, a gate, a source, and a drain;
the first insulating layer disposed on one side of the plurality of thin film transistors away from the substrate;
a plurality of first vias penetrating through at least the first insulating layer;
a first metal layer disposed on one side of the first insulating layer away from the substrate, the first metal layer includes a plurality of pads, and at least some of the plurality of pads are connected to the drains of the corresponding ones of the plurality of thin film transistors through the plurality of first vias.

Optionally, in some embodiments of the present disclosure, the metal oxide layer further includes a third sub-protection portion, and the third sub-protection portion covers the first metal layer.

Optionally, in some embodiments of the present disclosure, the third sub-protection portion includes a plurality of protection members, the plurality of protection members cover the corresponding ones of the plurality of pads, and the light-emitting diodes are connected to the corresponding ones of the plurality of pads through the plurality of protection members.

Optionally, in some embodiments of the present disclosure, the thin film transistor layer further includes:
a second insulating layer disposed between the plurality of thin film transistors and the first insulating layer, the second insulating layer is an inorganic material, the first insulating layer is an organic material, and the first via further penetrates through the second insulating layer.

Accordingly, embodiments of the present disclosure further provide a method of manufacturing a display panel, wherein the method includes:
providing a substrate;
forming an array composite layer on the substrate, the array composite layer exposing the substrate and forming a first slope that divides the display panel into an edge portion and a non-edge portion at least partially surrounded by the edge portion;
transferring a plurality of light-emitting diodes on the array composite layer; and
manufacturing an encapsulation layer on the plurality of light-emitting diodes, and the encapsulation layer being disposed in contact with the substrate at the edge portion.

Optionally, in some embodiments of the present disclosure, said manufacturing an encapsulation layer on the plurality of light-emitting diodes includes disposing a cover plate layer and an optical adhesive layer on the plurality of light-emitting diodes;
wherein the optical adhesive layer is disposed between the cover plate layer and the plurality of light-emitting diodes, and at the edge portion, the optical adhesive layer contacts the substrate and connects the substrate and the cover plate layer.

Optionally, in some embodiments of the present disclosure, said forming an array composite layer on the substrate includes:
forming a thin film transistor layer on the substrate, forming a first insulating layer on the thin film transistor layer, the thin film transistor layer including a plurality of thin film transistors disposed on the substrate, a second insulating layer disposed on the plurality of thin film transistors, the second insulating layer being an inorganic material, the first insulating layer being an organic material, each of the plurality of thin film transistors including at least a semiconductor layer, a gate insulating layer, a gate, a source, and a drain;
forming at least one first via on the first insulating layer, and removing the first insulating layer at the edge portion; and
forming a hole in the second insulating layer so that the first via also penetrates through the second insulating layer, and simultaneously removing the second insulating layer and other films in the array composite layer at the edge portion;
wherein the first insulating layer, the second insulating layer, and the other films in the array composite layer form a second slope at the edge portion.

Optionally, in some embodiments of the present disclosure, said forming the array composite layer further includes steps after forming a hole in the second insulating layer:
forming a first metal layer on the first insulating layer, patterning the first metal layer to form a plurality of pads, and at least some of the plurality of pads being electrically connecting to the drain through the first via.

Optionally, in some embodiments of the present disclosure, said forming the array composite layer further includes steps after forming a first metal layer on the first insulating layer:
forming a metal oxide layer on the first metal layer; and patterning the metal oxide layer to form a first sub-protection portion, a second sub-protection portion, and a third sub-protection portion; the first sub-protection portion covering the second slope to form the first slope, and extending to the edge portion to contact the substrate; a whole surface of the second sub-protection portion being disposed on the first metal layer; the third sub-protection portion covering the first metal layer; the third sub-protection portion including a plurality of protection members; and the plurality of protection members covering the corresponding one of the plurality of pads.

### BENEFICIAL EFFECTS

In the embodiments of the present disclosure, a display panel and a method of manufacturing a display panel are provided. The display panel includes an edge portion and a non-edge portion at least partially surrounded by the edge portion. The display panel includes a substrate; an array composite layer disposed on the substrate; a plurality of light-emitting diodes disposed on the array composite layer; and an encapsulation layer disposed on the plurality of light-emitting diodes. At the edge portion, the array composite layer exposes the substrate, and the encapsulation layer is disposed in contact with the substrate. In the present disclosure, at the edge portion, the array composite layer exposes the substrate, and the encapsulation layer is disposed in contact with the substrate to form an encapsulation sealing structure between the encapsulation layer and the substrate. When the sealing structure is located between the frame portion and the display portion, the array composite layer is prevented from being exposed at the side of the display panel, so that moisture or oxygen can be prevented from diffusing or being transmitted to the interior of the display panel through the array composite layer, thereby improving the service life and reliability of the display panel. Meanwhile, when the sealing structure is located between two adjacent pixels or light-emitting diodes in the display portion, the sealing structure blocks the diffusion or transmission channel of moisture or oxygen, so as to avoid the expansion of display defects, thereby improving the service life and reliability of the display panel.

### BRIEF DESCRIPTION OF THE DRAWINGS

In order to more clearly describe the technical solutions in the specific embodiments of the present disclosure or in the related arts, hereinafter, the appended drawings used for describing the specific embodiments or the related arts will be briefly introduced. Apparently, the appended drawings described below are only directed to some embodiments of the present disclosure, and for a person skilled in the art, without expenditure of creative labor, other drawings can be derived on the basis of these appended drawings.
FIG. 1 is a first schematic plan view of a first type of display panel according to Embodiment 1 of the present disclosure;
FIG. 2 is a second schematic plan view of a first type of display panel according to Embodiment 1 of the present disclosure;
FIG. 3 is a schematic cross-sectional view of a partial structure of a first type of display panel according to Embodiment 1 of the present disclosure;
FIG. 4 is a partial plan view of a second type of display panel according to Embodiment 1 of the present disclosure;
FIG. 5 is a schematic cross-sectional view of FIG. 4 along a dotted line direction D-D;
FIG. 6 is a schematic diagram showing steps in a method of manufacturing a display panel according to Embodiment 2 of the present disclosure;
FIG. 7 is a schematic diagram of other steps in a method of manufacturing a display panel according to Embodiment 2 of the present disclosure;
FIG. 8 is a schematic diagram of a first intermediate process in a method of manufacturing a display panel according to Embodiment 2 of the present disclosure;
FIG. 9 is a schematic diagram of a second intermediate process in a method of manufacturing a display panel according to Embodiment 2 of the present disclosure;
FIG. 10 is a schematic diagram of a third intermediate process in a method of manufacturing a display panel according to Embodiment 2 of the present disclosure;
FIG. 11 is a schematic diagram of a fourth intermediate process in a method of manufacturing a display panel according to Embodiment 2 of the present disclosure; and
FIG. 12 is a schematic diagram of a fifth intermediate process in a method of manufacturing a display panel according to Embodiment 2 of the present disclosure.

### DETAILED DESCRIPTION

Hereinafter, technical solution in embodiments of the present disclosure will be clearly and completely described with reference to the accompanying drawings in embodiments of the present disclosure. Apparently, the described embodiments are part of, but not all of, the embodiments of the present disclosure. All the other embodiments, obtained by a person with ordinary skill in the art on the basis of the embodiments in the present disclosure without expenditure of creative labor, belong to the protection scope of the present disclosure. In addition, it should be understood that the specific embodiments described herein are intended only to illustrate and explain the present disclosure and are not intended to limit the present disclosure. In the present disclosure, in the absence of contrary description, directional words such as "up" and "down" generally refer to the up and down in the actual use or working state of a device, and specifically the drawing direction in the accompanying drawings. While "inside" and "outside" are for profile of the device.

Embodiments of the present disclosure provide a display panel including an edge portion and a non-edge portion at least partially surrounded by the edge portion. The display panel includes a substrate; an array composite layer disposed on a substrate; a plurality of light-emitting diodes disposed on the array composite layer; and an encapsulation layer disposed on the plurality of light-emitting diodes; wherein at the edge portion, the array composite layer exposes the substrate, and the encapsulation layer is disposed in contact with the substrate.

The present disclosure also provides a method of manufacturing the above display panel. Detailed descriptions are given below. It should be noted that the order in which the following embodiments are described is not intended to limit the preferred order of the embodiments.

### Embodiment 1

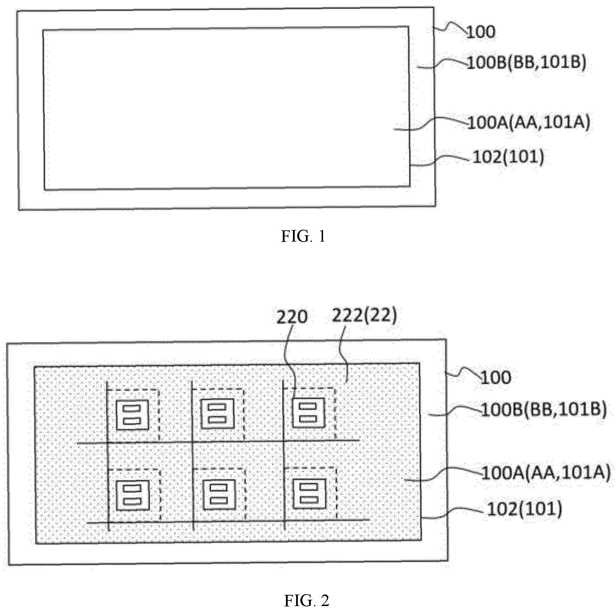

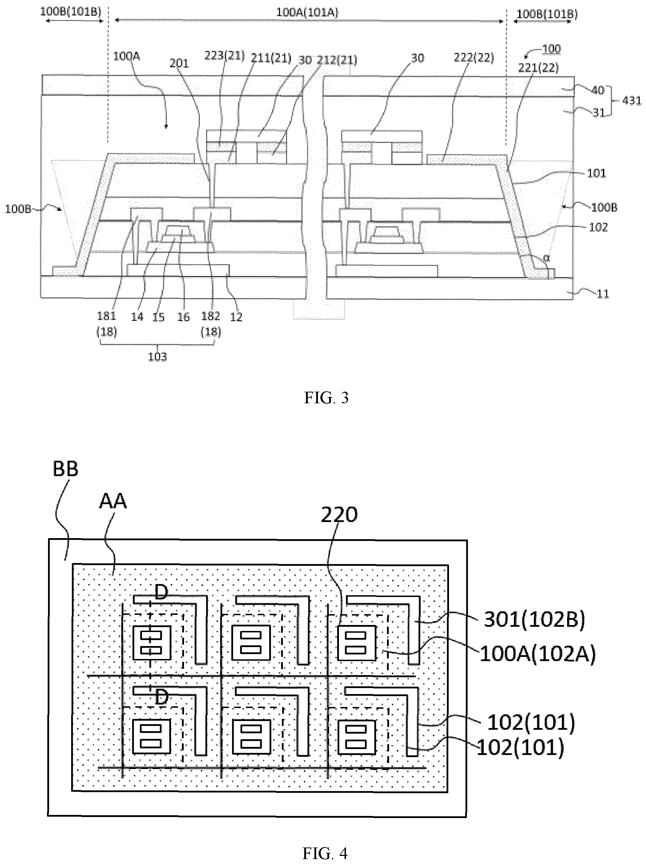

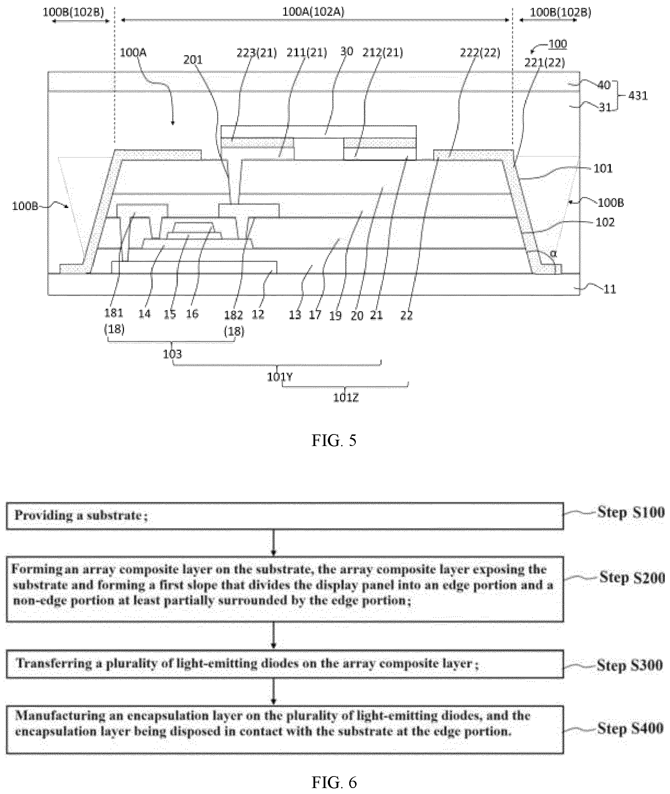

Referring to FIGs. 1 to 5, FIG. 1 is a first schematic plan view of a first type of display panel according to Embodiment 1 of the present disclosure, FIG. 2 is a second schematic plan view of a first type of display panel according to Embodiment 1 of the present disclosure, FIG. 3 is a schematic cross-sectional view of a partial structure of a first type of display panel according to Embodiment 1 of the present disclosure, FIG. 4 is a partial plan view of a second type of display panel according to Embodiment 1 of the present disclosure, and FIG. 5 is a schematic cross-sectional view of FIG. 4 along a dotted line direction D-D. FIGs. 1 to 3 illustrate a first type of display panel. Compared with FIG. 1, FIG. 2 illustrates the shape of the metal oxide layer. FIGs. 4 and 5 illustrate a second type of display panel. The features in embodiments of the first type of display panel may be combined with the features in embodiments of the second type of display panel.

Embodiments of the present disclosure provide a display panel 100 including an edge portion 100B and a non-edge portion 100A at least partially surrounded by the edge portion 100B. The display panel 100 includes a substrate 11, an array composite layer 101Z, a plurality of light-emitting diodes 30, and an encapsulation layer 431. The array composite layer 101Z is disposed on the substrate 11; the plurality of light-emitting diodes 30 are disposed on the array composite layer 101Z; and the encapsulation layer 431 is disposed on the plurality of light-emitting diodes 30. At the edge portion 100B, the array composite layer 101Z exposes the substrate 11, and the encapsulation layer 431 is disposed in contact with the substrate 11.

Specifically, the substrate 11 may be a glass substrate, but is not limited thereto.

In this embodiment, at the edge portion 100B, the array composite layer 101Z exposes the substrate 11, and the encapsulation layer 431 is disposed in contact with the substrate 11 to form an encapsulation sealing structure between the encapsulation layer 431 and the substrate 11. When the sealing structure is located between the frame portion BB and the display portion AA, the array composite layer 101Z is prevented from being exposed at the side of the display panel 100, so that moisture or oxygen can be prevented from diffusing or being transmitted to the interior of the display panel 100 through the array composite layer101Z, thereby improving the service life and reliability of the display panel 100. Meanwhile, when the sealing structure is located between two adjacent pixels or light-emitting diodes 30 in the display portion AA, the sealing structure blocks the diffusion or transmission channel of moisture or oxygen, so as to avoid the expansion of display defects, thereby improving the service life and reliability of the display panel.

In some embodiments, the encapsulation layer 431 includes a cover plate layer 40 and an optical adhesive layer 31 disposed between the cover plate layer 40 and the plurality of light-emitting diodes 30. At the edge portion 100B, the optical adhesive layer 31 connects the substrate 11 and the cover plate layer 40.

Specifically, the optical adhesive layer 31 may be an optically clear adhesive (OCA) or an optically clear resin (OCR).

Specifically, the cover plate layer 40 may be a glass cover plate, or a metal cover plate, or a ceramic cover plate, which is not limited herein.

Specifically, at the edge portion 100B, the optical adhesive layer 31 connects the substrate 11 and the cover plate layer 40 to form an encapsulation sealing structure.

Referring to the first type of display panel showing in FIGs. 1 to 3, in some embodiments, the display panel 100 includes a frame portion BB and a display portion AA at least partially surrounded by the frame portion BB. The edge portion 100B includes a first edge portion 101B. The non-edge portion 100A includes a first non-edge portion 101A. The first edge portion 101B corresponds to the frame portion BB. The first non-edge portion 101A corresponds to the display portion AA.

Specifically, as shown in FIGs. 1 to 3, the first edge portion 101B corresponds to the frame portion BB, and the first non-edge portion 101A corresponds to the display portion AA. That is to say, at the edge portion 100B, the array composite layer 101Z is retracted relative to the substrate 11, and the encapsulation layer 431 is disposed in contact with the substrate 11.

Specifically, as shown in FIG. 1, the display panel 100 includes an edge portion 100B (or a first edge portion 101B) and a non-edge portion 100A (or a first non-edge portion 101A). The edge portion 100B surrounds or partially surrounds the non-edge portion 100A. The boundary between the edge portion 100B and the non-edge portion 100A in FIG. 1 is the first slope 101 or/and the second slope 102 introduced in subsequent embodiments.

Specifically, the array composite layer 101Z may include structures such as driving circuits and wirings for driving the micro-light emitting diodes 30 to emit light.

Specifically, the display panel 100 includes a plurality of light-emitting diodes 30 disposed on the substrate 11. The light-emitting diodes 30 can be used as light sources of the backlight of the display panel, and the light-emitting diodes 30 can also be used as a part of the sub-pixels of the display panel that directly display images.

Specifically, as shown in FIG. 1, the first edge portion 101B refers to a portion close to the side of the display panel 100. Usually, the first edge portion 101B is located in the non-display area or the frame portion BB.

Specifically, the non-edge portion 100A may include the display portion AA or may refer to the display portion AA.

Specifically, the first edge portion 101B partially surrounds the first non-edge portion 101A, or the first edge portion 101B surrounds the first non-edge portion 101A. Specifically, the array composite layer 101Z is retracted relative to the substrate 11, which means that, on the plane of the display panel, the edge of the array composite layer 101Z does not coincide with the edge of the substrate 11, and the edge of the array composite layer 101Z is located on the side of the edge of the array composite layer 101Z that is close to the center of the substrate 11.

Specifically, the array composite layer 101Z is retracted relative to the substrate 11 means that the edge of the substrate 11 is located outside the edge of the array composite layer 101Z on the plane of the display panel.

In this embodiment, at the edge portion 100B, the array composite layer 101Z is retracted relative to the substrate 11 to expose the substrate 11, and the encapsulation layer 431 is disposed in contact with the substrate 11, so that the array composite layer 101Z is prevented from being exposed at the side of the display panel 100, in this way, moisture or oxygen can be prevented from diffusing or being transmitted to the interior of the display panel 100 through the array composite layer 101Z, thereby improving the service life and reliability of the display panel.

Referring to FIGs. 4 and 5, in some embodiments, the display panel 100 includes a frame portion BB and a display portion AA at least partially surrounded by the frame portion BB. The display portion AA includes a plurality of light-emitting diodes 30, and at least one opening 301 is disposed between at least part of two adjacent light-emitting diodes 30. The edge portion 100B includes a second edge portion 102B corresponding to the opening 301, and the non-edge portion 100A includes a second non-edge portion 102A corresponding to the light-emitting diode 30 on one side of the opening 301.

Specifically, at least one opening 301 is disposed between at least part of two adjacent light-emitting diodes 30, that is to say, the display panel 100 includes at least one opening 301.

Specifically, the second edge portion 102B corresponds to the opening 301, and the second non-edge portion 102A corresponds to the light-emitting diode 30 on the side of the opening 301. That is, in this embodiment, the edge portion 100B or the second edge portion 102B is disposed between two adjacent sub-pixels or two adjacent light-emitting diodes 30 in the display portion AA. Since two adjacent light-emitting diodes 30 may need to be driven by the same scanning line or the same data line or the like, it is difficult to provide the second edge portion 102B to completely surround the corresponding sub-pixels or the light-emitting diodes 30, therefore, it is necessary to form the second edge portion 102B by providing the opening 301.

Specifically, as shown in FIGs. 4 and 5, the display panel 100 includes an edge portion 100B (or a second edge portion 102B) and a non-edge portion 100A (or a second non-edge portion 102A). The edge portion 100B surrounds or partially surrounds the non-edge portion 100A. The non-edge portion 100A. The boundary between the edge portion 100B and the non-edge portion 100A in FIG. 4 is the first slope 101 or/and the second slope 102 introduced in subsequent embodiments, which is also an edge of the opening.

Specifically, as shown in FIG. 4 and FIG. 5, in the edge portion 100B (or the second edge portion 102B), the array composite layer 101Z exposes the substrate 11, and the encapsulation layer 431 is disposed in contact with the substrate 11 to form an encapsulation sealing structure between the encapsulation layer 431 and the substrate 11. When the sealing structure is located between two adjacent pixels or light-emitting diodes 30 in the display portion AA, the sealing structure blocks the diffusion or transmission channel of moisture or oxygen, so as to avoid the expansion of display defects, thereby improving the service life and reliability of the display panel.

In this embodiment, the first type of display panel 100 shown in FIGs. 1 to 3 and the second type of display panel shown in FIGs. 4 and 5 are introduced. However, the first edge portion 101B of the first type of display panel and the second edge portion 102B of the second type of display panel may be provided in the same display panel. In this case, the beneficial effects of both are simultaneously achieved.

Since the division of the first edge portion 101B and the first non-edge portion 101A in the above embodiments is the same as the division of the second edge portion 102B and the second non-edge portion 102A, in the embodiments, the structures are described in detail in terms of the edge portion 100B and the non-edge portion 100A.

In some embodiments, as shown in FIGs. 1-5, the array composite layer 101Z forms a first slope 101 at a boundary between the edge portion 100B and the non-edge portion 100A, the optical adhesive layer 31 covers the first slope 101, and an included angle formed between the first slope 101 and the substrate 11 of the edge portion 100B is an obtuse angle.

Specifically, the array composite layer 101Z is retracted to form the first slope 101. The included angle formed between the first slope 101 and the substrate 11 of the edge portion 100B is an obtuse angle, which can prevent the existence of air bubbles between the optical adhesive layer 31 and the array composite layer 101Z when they are attached.

Specifically, as shown in FIGs. 3 and 5, the first slope 101 or the extension lines of the first slope 101 intersects with the substrate 11, and the included angle between the first slope 101 and the substrate 11 of the edge portion 100B refers to the included angle located at the edge portion 100B, or the included angle located at the side of the first slope 101 away from the non-edge portion 100A.

Specifically, as shown in FIGs. 3 and 5, the first slope 101 divides the display panel into an edge portion 100B and a non-edge portion 100A. On the plane of the display panel, the side of the first slope 101 close to the light-emitting diodes 30 is the non-edge portion 100A, and the side of the first slope 101 away from the light-emitting diodes 30 is an edge portion 100B.

In some embodiments, the array composite layer 101Z includes a conductive metal oxide layer 22 and a thin film transistor layer 101Y. The thin film transistor layer 101Y forms a second slope 102 corresponding to the first slope 101. The metal oxide layer 22 includes a first sub-protection portion 221, the first sub-protection portion 221 covers the second slope 102 and extends to the edge portion 100B to contact the substrate 11. The optical adhesive layer 31 covers the first sub-protection portion 221. In addition, the optical adhesive layer 31 may further cover a portion of the substrate 11 that protrudes relative to the first sub-protection portion 221 on the plane of the display panel.

Specifically, the portion of the substrate 11 that protrudes relative to the first sub-protection portion 221 on the plane of the display panel means that the first sub-protection portion 221 is retracted relative to the substrate 11 on the plane of the display panel, and the substrate 11 protrudes relative to the first sub-protection portion 221 on the plane of the display panel.

Specifically, the thin film transistor layer 101Y refers to a plurality of thin film layers between the metal oxide layer 22 and the substrate 11, and the thin film transistor layer 101Y may include a plurality of thin film transistors 103.

Specifically, the conductive metal oxide layer 22 may be indium tin oxide (ITO).

Specifically, as shown in FIGs. 2 and 3, in the first type of display panel, the metal oxide layer 22 is disposed on a whole surface. The metal oxide layer 22 includes an oxide opening 220 corresponding to the light-emitting diodes 30 or the pads. The oxide opening 220 exposes the pad connected to the light-emitting diode 30.

Specifically, the first sub-protection portion 221 covers the second slope 102 and extends to the edge portion 100B to contact the substrate 11. The first sub-protection portion 221 has a good capability of blocking moisture and oxygen, which can prevent the thin film transistor layer 101Y from being exposed at the edge portion 100B or form a barrier to prevent the propagation of moisture and oxygen, and prevent moisture or the oxygen from entering the interior of the display panel through the thin film transistor layer 101Y, or prevent moisture or the oxygen from being transferred inside the display panel through the thin film transistor layer 101Y, thereby improving the life and reliability of the display panel.

Specifically, the first sub-protection portion 221 covers the second slope 102, and extends to the edge portion 100B to contact the substrate 11, thereby blocking the diffusion path of moisture or oxygen, thus isolating moisture or oxygen.

In some embodiments, an included angle formed between the second slope 102 and the substrate 11 of the edge portion 100B ranges from 110 degrees to 140 degrees.

Specifically, the included angle alpha (α) formed between the second slope 102 and the substrate 11 of the edge portion 100B ranges from 110 degrees to 140 degrees, so that the first sub-protection portion 221 can cover or attach to the second slope 102 well, and extends to the edge portion 100B to contact the substrate 11, thereby improving the covering performance and the contact performance of the metal oxide layer 22, and avoiding generation of cracks and the like.

In some embodiments, the array composite layer 101Z further includes a first insulating layer 20 disposed between the thin film transistor layer 101Y and the metal oxide layer 22. The metal oxide layer 22 includes a second sub-protection portion 222 disposed at the non-edge portion 100A. A whole surface of the second sub-protection portion 222 is disposed on the first insulating layer 20.

Specifically, a whole surface of the second sub-protection portion 222 is disposed on the first insulating layer 20, so as to further block moisture or oxygen, and the second sub-protection portion 222 functions as a protective layer. Even if moisture or oxygen enters the optical adhesive layer 31, the second sub-protection portion 222 can block moisture or oxygen from entering the thin film transistor 103.

In some embodiments, the first insulating layer 20 is a flat layer of an organic material.

Specifically, the first insulating layer 20 is flat layer of an organic material, which can play a planarizing role, so that the metal oxide layer 22 is well attached to the thin film transistor layer 101Y without undesirable cracks.

In some embodiments, the layer structures of the thin film transistor layer 101Y include a plurality of thin film transistors 103, a first insulating layer 20, a plurality of first vias 201, and a first metal layer 21. The plurality of thin film transistors 103 are disposed on the substrate 11. Each of the plurality of thin film transistors 103 includes at least a semiconductor layer 14, a gate insulating layer 15, a gate 16, a source 181, and a drain 182. The first insulating layer 20 is disposed on one side of the plurality of thin film transistors 103 away from the substrate 11. The plurality of first vias 201 penetrate through at least the first insulating layer 20. The first metal layer 21 is disposed on the side of the first insulating layer 20 away from the substrate 11. The first metal layer 21 includes a plurality of pads, and at least some of the plurality of pads are connected to the drains 182 of the corresponding thin film transistors 103 through the first vias 201.

Specifically, the plurality of pads include first pads 211 and second pads 212, and two electrodes of the micro light-emitting diode 30 are respectively connected to the corresponding first pads 211 and the corresponding second pads 212.

Specifically, the thin film transistor 103 drives the corresponding micro light-emitting diode 30 to emit light.

In some embodiments, the metal oxide layer 22 further includes a third sub-protection portion 223, and the third sub-protection portion 223 covers the first metal layer 21.

Specifically, the metal oxide layer 22 has good conductive properties and good capability of blocking moisture and oxygen, the third sub-protection portion 223 covers the first metal layer 21, and the third sub-protection portion 223 plays a role in protecting the first metal layer 21, so that the third sub-protection portion 223 can prevent the first metal layer 21 from being oxidized or corroded even if moisture or oxygen enters the interior of the display panel.

In some embodiments, the thin film transistor layer 101Y further includes a second insulating layer 19 disposed between the plurality of thin film transistors 103 and the first insulating layer 20. The second insulating layer 19 is an inorganic material. The first insulating layer 20 is an organic material. The first via 201 further penetrates through the second insulating layer 19.

Specifically, the first insulating layer 20 is an organic material, which provides a flat attachment surface for the metal oxide layer 22 and provides a good flatness for the micro light-emitting diodes 30, thereby improving the transfer yield of the micro light-emitting diodes.

Specifically, the second insulating layer 19 is an inorganic material and has good capability of blocking moisture and oxygen. Even if moisture or oxygen enters the interior of the display panel, the second insulating layer 19 can block moisture or oxygen from entering the thin film transistor 103.

It should be noted that the layer structures of the display panel 100 illustrated in FIGs. 3 and 5 include a substrate 11, a light shielding layer 12, a buffer layer 13, a semiconductor layer 14, a gate insulating layer 15, a gate 16, an interlayer insulating layer 17, a source and drain metal layer 18, a second insulating layer 19, a first insulating layer 20, a first metal layer 21, a metal oxide layer 22, micro light-emitting diodes 30, an optical adhesive layer 31, and a cover plate layer 40 stacked in sequence. The source and drain metal layer 18 is patterned to form a source 181 and a drain 182.

### Embodiment 2

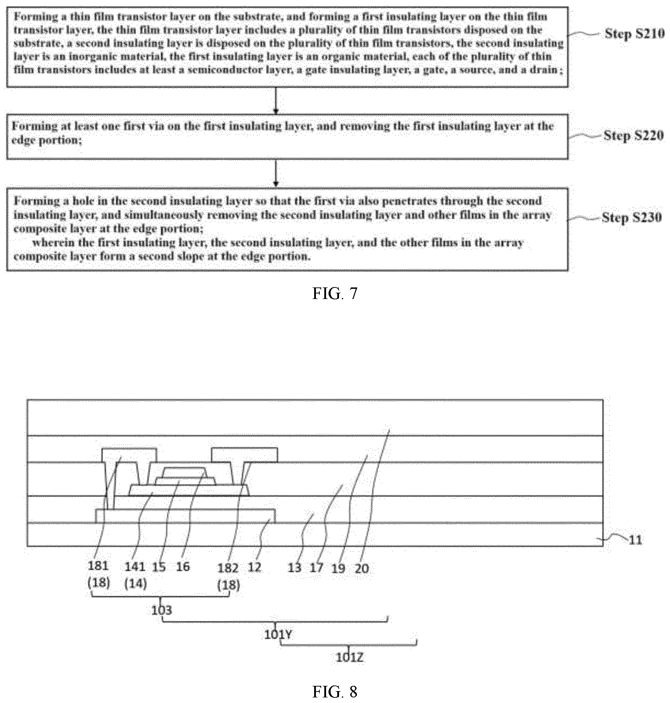

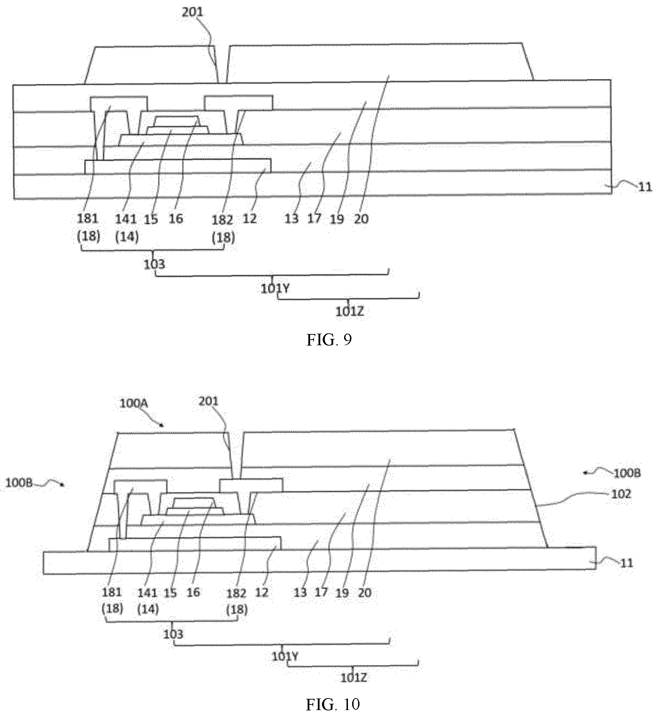

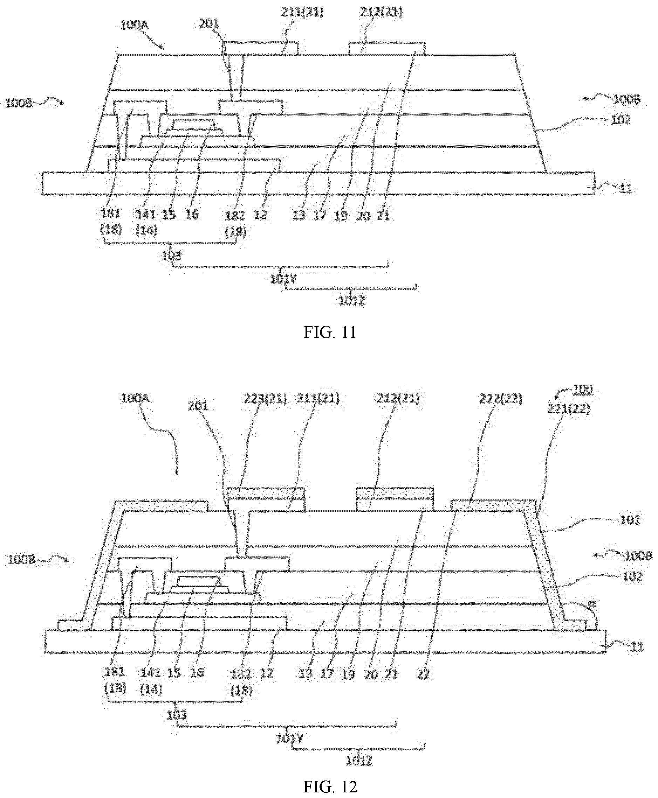

Referring to FIGs. 6 to 11, FIG. 6 is a schematic diagram showing steps in a method of manufacturing a display panel according to Embodiment 2 of the present disclosure, FIG. 7 is a schematic diagram of other steps in a method of manufacturing a display panel according to Embodiment 2 of the present disclosure, FIG. 8 is a schematic diagram of a first intermediate process in a method of manufacturing a display panel according to Embodiment 2 of the present disclosure, FIG. 9 is a schematic diagram of a second intermediate process in a method of manufacturing a display panel according to Embodiment 2 of the present disclosure, FIG. 10 is a schematic diagram of a third intermediate process in a method of manufacturing a display panel according to Embodiment 2 of the present disclosure, FIG. 11 is a schematic diagram of a fourth intermediate process in a method of manufacturing a display panel according to Embodiment 2 of the present disclosure, and FIG. 12 is a schematic diagram of a fifth intermediate process in a method of manufacturing a display panel according to Embodiment 2 of the present disclosure.

The display panels 100 in any of the above embodiments may be manufactured by using the method of manufacturing the display panel in this embodiment.

Specifically, as shown in FIG. 6, this embodiment provides a method of manufacturing a display panel, including steps: S100, S200, S300, and S400.

S100, providing a substrate.

Specifically, providing a substrate 11.

S200, forming an array composite layer on the substrate. The array composite layer exposes the substrate and forms a first slope, the first slope divides the display panel into an edge portion and a non-edge portion at least partially surrounded by the edge portion.

Specifically, forming an array composite layer 101Z on the substrate 11. The array composite layer 101Z is retracted relative to the substrate 11 to form a first slope 101. The first slope 101 divides the display panel 100 into an edge portion 100B and a non-edge portion 100A at least partially surrounded by the edge portion 100B.

S300, transferring a plurality of light-emitting diodes on the array composite layer.

Specifically, transferring a plurality of light emitting diodes 30 on the array composite layer 101Z.

S400, manufacturing an encapsulation layer on the plurality of light-emitting diodes, and the encapsulation layer are disposed in contact with the substrate at the edge portion.

Specifically, manufacturing an encapsulation layer 431 on the plurality of light-emitting diodes 30, and the encapsulation layer 431 are disposed in contact with the substrate 11 at the edge portion 100B.

In some embodiments, said manufacturing an encapsulation layer on the plurality of light-emitting diodes includes disposing a cover plate layer 40 and an optical adhesive layer 31 on the plurality of light-emitting diodes 30. The optical adhesive layer 31 is disposed between the cover plate layer 40 and the plurality of light-emitting diodes 30. At the edge portion 100B, the optical adhesive layer 31 contacts the substrate and is connected to the cover plate layer 40.

In some embodiments, as shown in FIG. 7, forming the array composite layer includes steps: S210, S220, and S230.

In S210, forming a thin film transistor layer on the substrate, and forming a first insulating layer on the thin film transistor layer. The thin film transistor layer includes a plurality of thin film transistors disposed on the substrate, a second insulating layer disposed on the plurality of thin film transistors. The second insulating layer is an inorganic material. The first insulating layer is an organic material. Each of the plurality of thin film transistors includes at least a semiconductor layer, a gate insulating layer, a gate, a source, and a drain.

Specifically, as shown in FIG. 8, forming a thin film transistor layer 101Y on the substrate 11, and forming a first insulating layer 20 on the thin film transistor layer 101Y. The thin film transistor layer 101Y includes a plurality of thin film transistors 103 disposed on the substrate 11, a second insulating layer 19 disposed on the plurality of thin film transistors 103. The second insulating layer 19 is an inorganic material. The first insulating layer 20 is an organic material. Each of the plurality of thin film transistors 103 includes at least a semiconductor layer 14, a gate insulating layer 15, a gate 16, a source 181, and a drain 182.

S220, forming at least one first via 201 on the first insulating layer, and removing the first insulating layer at the edge portion 100B.

Specifically, as shown in FIG. 9, forming at least one first via 201 on the first insulating layer, and removing the first insulating layer at the edge portion 100B.

S230, forming a hole in the second insulating layer so that the first via also penetrates through the second insulating layer, and simultaneously removing the second insulating layer and other films in the array composite layer at the edge portion. The first insulating layer, the second insulating layer, and the other films in the array composite layer form a second slope at the edge portion.

Specifically, as shown in FIG. 10, forming a hole in the second insulating layer 19 so that the first via 201 also penetrates through the second insulating layer 19, and simultaneously removing the second insulating layer 19 and other films in the array composite layer 101Z at the edge portion 100B. The first insulating layer 20, the second insulating layer 19, and the other films in the array composite layer 101Z form a second slope 102 at the edge portion 100B.

In some embodiments, as shown in FIG. 11, said forming the array composite layer 101Z further includes the following steps after forming a hole in the second insulating layer 19: forming a first metal layer 21 on the first insulating layer 20, patterning the first metal layer 21 to form a plurality of pads 211, and at least some of the plurality of pads 211 are electrically connecting to the drain 182 through the first via 201.

In some embodiments, as shown in FIG. 12, said forming the array composite layer 101Z further includes the following steps after forming a first metal layer 21 on the first insulating layer 20: forming a metal oxide layer 22 on the first metal layer 21; and patterning the metal oxide layer 22 to form a first sub-protection portion 221, a second sub-protection portion 222, and a third sub-protection portion 223. The first sub-protection portion 221 covers the second slope 102 to form the first slope 101, and extends to the edge portion 100B to contact the substrate 11. A whole surface of the second sub-protection portion is disposed on the first metal layer 20. The third sub-protection portion 223 covers the first metal layer 21. The third sub-protection portion 223 includes a plurality of protection members; and the plurality of protection members cover the corresponding one of the plurality of pads.

This embodiment has the same beneficial effects as those in Embodiment 1, which will not be described herein repeatedly.

In view of the foregoing, the display panel and the method of manufacturing the display panel provided in embodiments of the present disclosure have been described in detail above, and the principles and embodiments of the present disclosure are described by using specific examples herein. Descriptions of the above examples are merely intended to help understand the technical solutions and core ideas of the present disclosure. Meanwhile, for those skilled in the art, there will be changes in the specific implementation and application scope in accordance with the ideas of the present disclosure. In view of the foregoing, the contents of the specification should not be construed as limiting the present disclosure.

## Claims

1. A display panel comprising an edge portion and a non-edge portion at least partially surrounded by the edge portion, the display panel comprising:
a substrate;
an array composite layer disposed on the substrate;
a plurality of light-emitting diodes disposed on the array composite layer; and
an encapsulation layer disposed on the plurality of light-emitting diodes;
wherein at the edge portion, the array composite layer exposes the substrate, and the encapsulation layer is disposed in contact with the substrate.

2. The display panel according to claim 1, wherein the encapsulation layer comprises a cover plate layer and an optical adhesive layer disposed between the cover plate layer and the plurality of light-emitting diodes, and at the edge portion, the optical adhesive layer connects the substrate and the cover plate layer.

3. The display panel according to claim 2, wherein the display panel comprises a frame portion and a display portion at least partially surrounded by the frame portion;
the edge portion comprises a first edge portion corresponding to the frame portion, and the non-edge portion comprises a first non-edge portion corresponding to the display portion.

4. The display panel according to claim 2, wherein the display panel comprises a frame portion and a display portion at least partially surrounded by the frame portion;
the display portion comprises the plurality of the light-emitting diodes, and at least one opening is disposed between at least part of two adjacent light-emitting diodes; and
the edge portion comprises a second edge portion corresponding to the opening, and the non-edge portion comprises a second non-edge portion corresponding to the light-emitting diode on one side of the opening.

5. The display panel according to claim 2, wherein the array composite layer forms a first slope at a boundary between the edge portion and the non-edge portion, the optical adhesive layer covers the first slope, and an included angle formed between the first slope and the substrate of the edge portion is an obtuse angle.

6. The display panel according to claim 5, wherein the array composite layer comprises a conductive metal oxide layer and a thin film transistor layer, the thin film transistor layer forms a second slope corresponding to the first slope, the metal oxide layer comprises a first sub-protection portion, the first sub-protection portion covers the second slope and extends to the edge portion to contact the substrate, and the optical adhesive layer covers the first sub-protection portion.

7. The display panel according to claim 6, wherein an included angle formed between the second slope and the substrate of the edge portion ranges from 110 degrees to 140 degrees.

8. The display panel according to claim 6, wherein the array composite layer further comprises a first insulating layer disposed between the thin film transistor layer and the metal oxide layer, the metal oxide layer comprises a second sub-protection portion disposed at the non-edge portion, and a whole surface of the second sub-protection portion is disposed on the first insulating layer.

9. The display panel according to claim 8, wherein the first insulating layer is a flat layer of an organic material.

10. The display panel according to claim 8, wherein layer structures of the thin film transistor layer comprise:
a plurality of thin film transistors disposed on the substrate, each of the plurality of thin film transistors comprises at least a semiconductor layer, a gate insulating layer, a gate, a source, and a drain;
the first insulating layer disposed on one side of the plurality of thin film transistors away from the substrate;
a plurality of first vias penetrating through at least the first insulating layer;
a first metal layer disposed on one side of the first insulating layer away from the substrate, the first metal layer comprises a plurality of pads, and at least some of the plurality of pads are connected to the drains of the corresponding ones of the plurality of thin film transistors through the plurality of first vias.

11. The display panel according to claim 10, wherein the metal oxide layer further comprises a third sub-protection portion, and the third sub-protection portion covers the first metal layer.

12. The display panel according to claim 11, wherein the third sub-protection portion comprises a plurality of protection members, the plurality of protection members cover the corresponding ones of the plurality of pads, and the light-emitting diodes are connected to the corresponding ones of the plurality of pads through the plurality of protection members.

13. The display panel according to claim 10, wherein the thin film transistor layer further comprises:
a second insulating layer disposed between the plurality of thin film transistors and the first insulating layer, the second insulating layer is an inorganic material, the first insulating layer is an organic material, and the plurality of first vias further penetrate through the second insulating layer.

14. A method of manufacturing a display panel, comprising:
providing a substrate;
forming an array composite layer on the substrate, the array composite layer exposing the substrate and forming a first slope that divides the display panel into an edge portion and a non-edge portion at least partially surrounded by the edge portion;
transferring a plurality of light-emitting diodes on the array composite layer; and
manufacturing an encapsulation layer on the plurality of light-emitting diodes, and the encapsulation layer being disposed in contact with the substrate at the edge portion.

15. The method according to claim 14, wherein said manufacturing an encapsulation layer on the plurality of light-emitting diodes comprises disposing a cover plate layer and an optical adhesive layer on the plurality of light-emitting diodes;
wherein the optical adhesive layer is disposed between the cover plate layer and the plurality of light-emitting diodes, and at the edge portion, the optical adhesive layer contacts the substrate and connects the substrate and the cover plate layer.

16. The method according to claim 15, wherein said forming an array composite layer on the substrate comprises:
forming a thin film transistor layer on the substrate, forming a first insulating layer on the thin film transistor layer, the thin film transistor layer comprising a plurality of thin film transistors disposed on the substrate, a second insulating layer disposed on the plurality of thin film transistors, the second insulating layer being an inorganic material, the first insulating layer being an organic material, each of the plurality of thin film transistors comprising at least a semiconductor layer, a gate insulating layer, a gate, a source, and a drain;
forming at least one first via on the first insulating layer, and removing the first insulating layer at the edge portion; and
forming a hole in the second insulating layer so that the first via also penetrates through the second insulating layer, and simultaneously removing the second insulating layer and other films in the array composite layer at the edge portion;
wherein the first insulating layer, the second insulating layer, and the other films in the array composite layer form a second slope at the edge portion.

17. The method according to claim 16, wherein said forming the array composite layer further comprises steps after forming a hole in the second insulating layer:
forming a first metal layer on the first insulating layer, patterning the first metal layer to form a plurality of pads, and at least some of the plurality of pads being electrically connecting to the drain through the first via.

18. The method according to claim 17, wherein said forming the array composite layer further comprises steps after forming a first metal layer on the first insulating layer:
forming a metal oxide layer on the first metal layer; and patterning the metal oxide layer to form a first sub-protection portion, a second sub-protection portion, and a third sub-protection portion; the first sub-protection portion covering the second slope to form the first slope, and extending to the edge portion to contact the substrate; a whole surface of the second sub-protection portion being disposed on the first metal layer; the third sub-protection portion covering the first metal layer; the third sub-protection portion comprising a plurality of protection members; and the plurality of protection members covering the corresponding one of the plurality of pads.
